Europäisches Patentamt

European Patent Office

Office européen des brevets

(19)

(11) EP 0 757 385 A2

(12) EUROPÄISCHE PATENTANMELDUNG

(43) Veröffentlichungstag:
05.02.1997 Patentblatt 1997/06

(51) Int Cl.6: H01L 23/427

(21) Anmeldenummer: 96112248.8

(22) Anmeldetag: 30.07.1996

(84) Benannte Vertragsstaaten:
BE CH DE FR IT LI NL

(30) Priorität: 31.07.1995 DE 19527674

(71) Anmelder: ANCeram GmbH & Co. KG
95463 Bindlach (DE)

(72) Erfinder:
• Brunner, Dieter Dr..
D-95448 Bayreuth, (DE)

• Töpfer, Manfred
D-14339 Berlin, (DE)
• Die andere Erfinder haben auf ihre Nennung
verzichtet

(74) Vertreter: Grimm, Ekkehard, Dipl.-Phys.
Kurt-Blaum-Platz 1
63450 Hanau (DE)

(54) Kühleinrichtung für elektronische Schaltungen

(57) Kühleinrichtung, insbesondere für elektronische Schaltungen, mit mindestens einem Wärmerohr, das an seinem unten liegenden Ende einen Verdampfer aufweist und an seinem oben liegenden Ende mit Kühlelementen versehen ist, wobei der Verdampfer mindestens eine Kammer für zu verdampfendes, flüssiges Wärmeübertragungsmittel umfaßt, wobei der erzeugte Dampf im Verdampfer des Wärmerohrs im Bereich der Kühlelemente kondensiert und das Kondensat in die Kammer zurückfließt und der so gebildete Kreislauf nach außen dicht abgeschlossen ist, die dadurch gekennzeichnet ist, daß der Verdampfer aus einer wärmeleitenden Keramik mit einer Wärmeleiffähigkeit von mindestens $\lambda = 90$

$$\frac{\text{Watt}}{\text{m} \cdot \text{K}}$$

(bei 20°C) gebildet ist und daß der Verdampfer mindestens zwei Einzelkammern aufweist, die jeweils mit einem Wärmerohr strömungsmäßig ver bunden sind, wobei in die einzelnen Kammern unterschiedliche Wärmeübertragungsmittel mit unterschiedlicher Verdampfungstemperatur eingefüllt sind.

FIG. 1

## Beschreibung

Die Erfindung betrifft eine Kühleinrichtung, insbesondere für elektronische Schaltungen, mit mindestens einem Wärmerohr, das an seinem unten liegenden Ende einen Verdampfer aufweist und an seinem oben liegenden Ende mit Kühlelementen versehen ist, wobei der Verdampfer mindestens eine Kammer für zu verdampfendes, flüssiges Wärmeübertragungsmittel umfaßt, wobei der erzeugte Dampf im Verdampfer des Wärmerohrs im Bereich der Kühlelemente kondensiert und das Kondensat in die Kammer zurückfließt und der so gebildete Kreislauf nach außen dicht abgeschlossen ist.

Bei der Kühltechnik mittels Wärmerohren wird eine in dem Wärmerohr eingeschlossene Flüssigkeit an einer heißen Stelle verdampft (Verdampfer), strömt durch ein Rohr nach oben und kondensiert an den gekühlten Wänden (Kondensator) und läuft unter Schwerkraft als Kondensat zurück zu dem Verdampfer. Hierdurch wird ein Kreislauf im Innern des Rohrs hergestellt, ohne daß dazu Pumpen eingesetzt werden müssen. Die Wärmeübertragung von der Zone der Wärmezuführung (Verdampfer) zu der Wärmeabgabezone (Kondensator) erfolgt ohne Verluste (adiabatische Zone), und es ist daher möglich, Verdampfer und Kondensator in größeren Abständen voneinander zu installieren.

Durch die einfache Konstruktion der Wärmerohre und deren wartungsfreie Funktion, die ohne Energieverbrauch abläuft, werden solche in vielen Branchen zur Kühlung eingesetzt. Hiervon sind unter anderem die Bereiche der Haushaltsgeräte, der Sonnenkollektoren sowie die Elektronikindustrie, wo mit solchen Wärmerohren elektronische Komponenten gekühlt werden, zu nennen.

Der Verdampfer eines Wärmerohrs besteht normalerweise aus einem quaderförmigen Aluminium- oder Kupferblock. Der Kondensator ist üblicherweise aus einer Reihe von dünnen Kühlblechen aus Aluminium oder Kupfer, die von den Wärmerohren durchquert werden und mit diesen fest verbunden sind, gebildet. Die Maße werden von den thermischen Kühlungsdaten sowie von der unmittelbar umgebenden Luftzone bestimmt, die ruhend oder ventiliert sein kann. Die Wärmerohre haben die Aufgabe, die vom Verdampfer kommende Wärme zum Kondensor mit den kleinstmöglichen Verlusten weiterzuleiten.

Nachteilig bei der vorstehend beschriebenen Ausführungsform ist die Verwendung von chlorierten Chlorfluorkohlenwasserstoffen als Kühlmedium sowie die Ausführung des Kondensators aus Aluminium oder Kupfer. Diese Materialien erfordern zur Isolation von elektronischen Bauteilen, die beispielsweise an den dazu vorbereiteten Flächen des Verdampfers zur Kühlung aufgebracht werden, die Zwischenfügung einer Isolierschicht, beispielsweise einer Keramikplatte, gegebenenfalls einer Kunststoffplatte. Der Wärmewiderstand wird hierbei durch den zweimaligen Übergang Metall-Keramik bzw. Keramik-Kupfer erhöht.

In den letzten Jahren ist man auch dazu übergegangen, Verdampfer in Form von Kupferrohren, die in einer wärmeleitenden Keramik eingebettet sind, aufzubauen. Allerdings ist hierbei der Wärmeübergang zwischen den Kupferrohren und der Keramik äußerst schlecht, außerdem entstehen Probleme durch den großen Unterschied in den Wärmeausdehnungskoeffizienten, so daß solche Verdampfer nicht zuverlässig arbeiten oder nur in eng begrenzten Temperaturbereichen zu verwenden sind.

Eine Kühleinrichtung gemäß dem Oberbegriff des Anspruchs 1 ist aus der US-PS 4,982,274 bekannt. Weiterhin ist aus der US-PS 4,912,548 ein Wärmerohr bekannt, das mit einem IC-Package integriert ist, um die von dem Bauteil erzeugte Wärme abzuführen, wobei das Bauteil in direktem Kontakt mit dem flüssigen Wärmeübertragungsmittel steht.

Ausgehend von dem vorstehend beschriebenen Stand der Technik und der damit verbundenen Problematik liegen der vorliegenden Erfindung die Aufgabe zugrunde, eine Kühleinrichtung zu schaffen, die in Verbindung mit unterschiedlichen Kühlmedien eingesetzt werden kann, die in Bezug auf Kühlmedien korrosionsbeständig ist und die insbesondere auch zur Kühlung von elektronischen Bauteilen geeignet ist.

Die vorstehende Aufgabe wird, ausgehend von einer Kühleinrichtung der eingangs beschriebenen Art, dadurch gelöst, daß der Verdampfer aus einer wärmeleitenden Keramik mit einer Wärmeleitfähigkeit von mindestens $\lambda = 90 \frac{\text{Watt}}{\text{M} \cdot \text{k}}$ (bei 20°C) gebildet ist und daß der Verdampfer mindestens zwei Einzelkammern aufweist, die jeweils mit einem Wärmerohr strömungsmäßig verbunden sind, wobei in die einzelnen Kammern unterschiedliche Wärmeübertragungsmittel mit unterschiedlicher Verdampfungstemperatur eingefüllt sind.

Zum einen wird es mit einem solchen Verdampfer aus einer gut wärmeleitfähigen Keramik mit einer Wärmeleitfähigkeit höher als 90 Watt pro m · K (bei 20°C) möglich, insbesondere auch dann, wenn an den Flächen des Verdampfers elektronische Bauteile einschließlich deren elektrischen Verbindungen angebracht werden, Wasser zu verwenden, wodurch der thermische Widerstand des Gesamtsystems deutlich gesenkt wird, da der Wärmetransport von Wasser wesentlich besser als derjenige nach dem Stand der Technik eingesetzten Chlorfluorkohlenwasserstoffe (FCKW) ist. Außerdem können die FCKW's durch umweltneutrale Stoffe ersetzt werden. Weiterhin kann, aufgrund der Möglichkeit, Wasser zu verwenden, die Effektivität des Gesamtkühlsystems wesentlich erhöht werden, wenn neben Wasser auch Methanol, Ethanol verwendet werden, so daß der Wärmetauscher bereits bei Temperaturen von -30°C über das Methanol effektiv wird, bei mittleren Temperaturen durch die Verdampfung von Ethanol oder Isopropanol und bei hohen Temperaturen durch Verdampfung des Wassers. Die einzelnen wärmeabführenden Flüssigkeiten werden in einzelne, getrennte Kammern des Wärmetauschers aus der wärmeleitenden Keramik eingefüllt, so daß der Wärmetauscher dann aus unterschiedlichen, geschlossenen Kreisläufen aufgebaut ist, von denen jeder aus einer Kammer im Wärmetauscher, einem damit verbundenen Rohr und einem Kondensator besteht. Weiterhin können mit der erfindungsgemäßen Kühleinrichtung mehrere elektronische Bauteile oder -komponenten auf der Oberfläche des Verdampfers angeordnet und gleichzeitig elektrisch miteinander verbunden werden. In einem solchen Fall kann das Material des Verdampfers ein Substrat ersetzen bzw. ergänzen, auf dem üblicherweise solche elektronischen Komponenten und Bauteile angeordnet werden.

Für eine gute Isolation gegenüber elektronischen Bauteilen oder Schaltungen, die mittels solcher Kühleinrichtungen gekühlt werden sollen, werden Keramiken mit einem elektrischen Widerstand oberhalb von $10^{10}\ \Omega$ · cm bevorzugt. Materialien, die die vorstehend genannten Eigenschaften, d.h. die Wärmeleitfähigkeit von mindestens 90 Watt pro m · K und einen elektrischen Widerstand oberhalb von $10^{10}\ \Omega$ · cm, erfüllen, sind Siliziumnitrid, Siliziumkarbid, Berylliumoxid oder Aluminiumnitrid, überlicherweise in reiner Form, mit der Ausnahme von Sinterhilfsmitteln, die üblicherweise in der Größenordnung von bis zu 3% vorliegen. Am bevorzugtesten ist Aluminiumnitrid, da es hinsichtlich seiner Wärmeleitfähigkeit und elektrischen Isolation am günstigsten ist, außerdem ist Alumniumnitrid nicht toxisch. Berylliumoxid besitzt eine Wärmeleitfähigkeit und einen elektrischen Widerstand, der mit Aluminiumnitrid vergleichbar ist, allerdings ist Berylliumoxid toxisch, so daß Berylliumoxid erst an Aluminiumnitrid nachgeordneter Stelle heranzuziehen ist. Siliziumnitrid ist dort einzusetzen, wo ein hoher elektrischer Widerstand gefordert ist, allerdings die Wärmeleitfähigkeit eine nicht so wesentliche Rolle spielt, so daß Siliziumnitrid einem Siliziumkarbid vorzuziehen ist. Als Sinterhilfsmittel eignen sich zum Beispiel für Siliziumnitrid Yttrium- und/oder Aluminiumoxid und für Aluminiumnitrid Yttrium- und/oder Kalziumoxid.

Um fertigungstechnisch in einfacher Weise einen solchen Verdampfer aus Keramik herzustellen, haben sich zwei schalenförmige Teile als bevorzugt erwiesen, die nach ihrer Herstellung miteinander verbunden werden und den Verdampfer mit einem Hohlraum im Innenraum bilden. Um die Wärmeaustauschfläche zwischen der wärmeleitenden Flüssigkeit und dem Verdampfer zu vergrößern, werden die Innenwände der Kammer des Verdampfers mit Erhebungen und Vertiefungen strukturiert. Solche Erhebungen können durch Zapfen und/oder Stege gebildet werden, mit einer Breite von 1 bis 10 mm, vorzugsweise von 2 bis 5 mm. Benachbarte Zapfen und/oder Stege werden hierbei vorzugsweise durch Freiräume getrennt, die eine Breite von 0,7 bis 5 mm, vorzugsweise von 1 bis 3 mm, haben. Gerade in Verbindung mit zwei schalenförmigen Teilen, die nach ihrer Herstellung zusammengeklebt werden, um den Verdampfer zu bilden, können solche Strukturierungen auf der Innenwand derart gebildet werden, daß die Vertiefungen in die Innenwand eingefräst oder eingeschnitten werden. Bei der kommerziellen Fertigung, d.h. bei der Massenherstellung, werden die Vertiefungen und Erhöhungen in der Innenwand durch Pressen der keramischen Pulver in eine Negativform oder Gießen keramischen Schlickers ebenfalls in eine Negativform ausgeführt. Solche Grünlinge werden dann anschließend gebrannt, so daß ein formstabiler Keramikkörper entsteht. Um die für den Wärmeaustausch zur Verfügung stehende Oberfläche im Innern des Wärmetauschers noch weiter zu erhöhen, werden die Zapfen und/oder Stege des einen schalenförmigen Teils spiegelbildlich zu dem anderen schalenförmigen Teil ausgebildet, so daß sich nach Zusammenfügen der beiden schalenförmigen Teile die zapfenförmigen Stege des einen schalenförmigen Teils an die Zapfen und Stege des anderen schalenförmigen Teils anschließen. Die bezüglich der Wärmeabfuhr neutrale Schicht ist die Symmetrieebene der Hohlkörperhälften.

Wie bereits vorstehend erwähnt ist, weist der Verdampfer mehrere Einzelkammern auf, die jeweils mit einem Wärmerohr strömungsmäßig verbunden sind, wobei die Möglichkeit gegeben ist, zur Erweiterung des Temperaturbereichs in die einzelnen Kammern unterschiedliche Wärmeübertragungsmittel mit unterschiedlicher Verdampfungstemperatur einzufüllen.

Für die Wärmerohre zwischen Verdampfer und Kondensator eignen sich insbesondere Kupferrohre oder Rohre aus einer Kupfer-Legierung. Allerdings tritt hierbei die Problematik der unterschiedlichen Wärmeausdehnungskoeffizienten zwischen dem Wärmerohr und dem Verdampfer auf, so daß vorzugsweise zwischen dem Verdampfer und dem Wärmerohr ein Zwischenstück zur elektrischen Isolierung und/oder zum Ausgleichen von Wärmeausdehnungen angeordnet wird. Zwischenstücke aus Keramik (z.B. Aluminiumoxid oder Magnesiumsilikat) werden mit dem Verdampfer verbunden. Die Keramiken werden in den Verdampfer eingeklebt oder es werden metallisierte Keramikrohre in den Verdampfer hartgelötet. Auch eignet sich ein Anbringen von Keramikrohren in dem Verdampfer mittels Aktivlöten, wobei als Lötmittel eine Titan-Silber- und/oder Kupfer enthaltende Legierung eingesetzt wird. Gegebenenfalls können die einzelnen Bauteile an den Verbindungsstellen vorbehandelt werden, beispielsweise durch Metallisierung, vorbehandelt werden. Gerade mit der Aktivlöt-Technik wird eine dichte, haltbare Verbindung zwischen den einzelnen Komponenten, beispielsweise dem Zwischenstück aus Keramik und dem Faltenbalg und dem Verdampfer bzw. dem Kühlabschnitt, erzielt. Zwischen Keramikrohr und Wärmerohr kann eventuell ein Faltenbalg (ebenfalls durch Hart- oder Weichlöten oder durch Einkleben des Faltenbalgs direkt in den Verdampfer) eingefügt werden.

Die beiden schalenförmigen Teile, aus denen der Verdampfer vorzugsweise aufgebaut wird, können mittels eines Epoxidharzes miteinander verklebt werden.

Dem Epoxidharz kann zusätzlich ein Füllmittel aus keramischen Pulvern, wie $SiO_2$, $SiC$ oder $Al_2O_3$, beigegeben werden, um den thermischen Ausdehnungskoeffizienten des Epoxidharz-Klebers zu senken und an die Klebepartner anzugleichen. Der gleiche Epoxidharz-Kleber kann auch zur Verbindung des Keramikrohrs mit dem Verdampfer eingesetzt werden.

Da eine solche Kühleinrichtung, wie sie vorstehend beschrieben ist, insbesondere für die Kühlung von elektronischen Bauteilen geeignet ist, werden für den Einsatz dieser Kühleinrichtung in diesem Bereich auf der Außenseite des Verdampfers Flächen zur Aufnahme von elektronischen Bauteilen vorgesehen, auf denen die Bauteile unmittelbar angeordnet und elektrisch versorgt werden können; durch die isolierende Wirkung der eingesetzten Keramikmaterialien kann der Verdampfer selbst unmittelbar den Trägerkörper für diese elektronischen Bauteile ohne Zwischenteile bilden, so daß ein hoher Kühlwirkungsgrad erzielt wird, was insbesondere bei Hochleistungselektroniken vorteilhaft ist.

Um eine kontinuierliche Strömung des verdampfenden Wärmeübertragungsmittels aufrecht zu erhalten, ohne daß sich im Bereich der Flächen der Stege und/ oder der Zapfen, die von dem Wärmeübertragungsmittel angeströmt werden, Totzonen bilden, werden die jeweiligen Flächen der Stege und/oder Zapfen, die von dem Wärmeübertragungsmittel angeströmt werden, abgeschrägt ausgebildet. Dies bedeutet, daß diese angeströmten Flächen Führungsflächen bilden, die das verdampfende Wärmeübertragungsmittel in Strömungsrichtung gesehen schräg zu den freien Kanten dieser Stege und Zapfen führen, so daß es zu den Kühlelementen frei aufsteigen kann. Es ist hierbei von Vorteil, alle Flächen der Stege und/oder Zapfen, die quer zur Strömungsrichtung des von dem Verdampfer zu den Kühlelementen hin aufsteigenden Wärmeübertragungsmittels verlaufen, in Strömungsrichtung gesehen abzuschrägen, so daß sie eine definierte Führung des Wärmeübertragungsmittels bewirken.

Weitere Einzelheiten und Merkmale der Erfindung ergeben sich aus der nachfolgenden Beschreibung von Ausführungsbeispielen anhand der Zeichnung. In der Zeichnung zeigt:

Figur 1    einen schematischen Aufbau einer erfindungsgemäßen Kühleinrichtung,

Figur 2    einen erfindungsgemäßen Verdampfer, teilweise aufgebrochen,

Figur 3    schematisch einen Schnitt durch eine alternative Ausführungsform eines Verdampfers mit drei Kammern,

Figur 4    eine Draufsicht auf eine Schale eines Verdampfers mit einzelnen quer zur Achse verlaufenden Stegen, die abgeschrägte Führungsflächen aufweisen,

Figur 5    einen Schnitt entlang der Schnittlinie IV-IV in Figur 4, und

Figur 6    eine vergrößerte Darstellung zweier Stege, ähnlich derjenigen, die in der Anordnung der Figuren 4 und 5 eingesetzt werden, zur Erläuterung der abgeschrägten Führungsflächen.

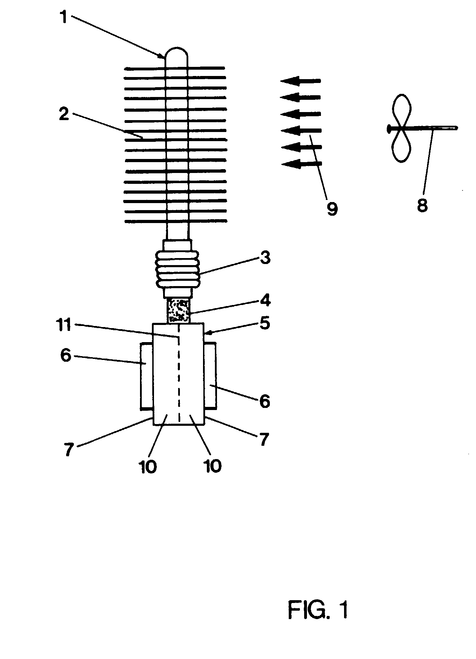

Die Kühleinrichtung, wie sie in der Figur 1 dargestellt ist, weist ein Wärmerohr 1 auf, das an seinem oberen Ende mit lamellenartigen Kühlelementen 2 verbunden ist, während es mit seinem unteren Ende über ein Zwischenstück in Form eines Faltenbalgs 3 und eines keramischen Zwischenrohrs 4 mit einem Verdampfer 5 verbunden ist. Diese Kühleinrichtung ist zur Kühlung elektronischer Bauteile 6 vorgesehen; hierzu sind an dem Verdampfer 5 ebene Flächen 7 vorhanden, an denen diese elektronischen Bauteile 6 direkt, ähnlich eines Trägersubstrats, aufgebracht werden können. Alternativ dazu können solche elektronischen Bauteile 6 auch mittels Klemmschienen oder anderer Befestigungseinrichtungen an dem Verdampfer 5 befestigt werden.

Der Verdampfer 5 ist aus Siliziumnitrid, Siliziumkarbid, Berylliumoxid oder Aluminiumnitrid gebildet. Die Wärmeleitfähigkeit dieser Keramiken liegt oberhalb von 90 Watt pro $m \cdot K$ (bei 20°C), darüberhinaus weisen diese Keramiken einen elektrischen Widerstand oberhalb von $\rho = 10^{10} \, \Omega \cdot cm$ auf. Im einzelnen liegen die üblichen Wärmeleitfähigkeiten von Siliziumnitrid bei 40 - 120 Watt pro $m \cdot K$, für Siliziumkarbid bei 25 - 100 Watt pro $m \cdot K$, bei Berylliumoxid bei 220 - 270 Watt pro $m \cdot K$ und für Aluminiumnitrid bei 70 - 250 Watt pro $m \cdot K$. Der elektrische Widerstand liegt für Siliziumnitrid bei $10^9 - 10^{14} \, \Omega \cdot cm$, für Siliziumkarbid bei $40 - 10^{10} \, \Omega \cdot cm$ und für Aluminiumnitrid bei $10^{11} - 10^{14} \, \Omega \cdot cm$.

Prinzipiell arbeiten solche Kühleinrichtungen mit Wärmerohr derart, daß innerhalb des Verdampfers 5 und des Wärmerohrs 1 ein geschlossener Hohlraum gebildet ist, der mit einer bestimmten Menge einer Flüssigkeit gefüllt ist. Im Ausgangszustand befindet sich diese Flüssigkeit im Bereich des Verdampfers 5. Wenn von den elektrischen Bauteilen 6 Wärme an den Verdampfer 5 abgegeben wird, wird durch diese Wärme die Flüssigkeit in dem Verdampfer erwärmt und verdampft, steigt in dem Wärmerohr 1 auf und wird im Bereich der Kühlelemente 2 gekühlt, so daß der Dampf auskondensiert und an der Wandung des Wärmerohrs wieder zurück unter Einwirkung der Schwerkraft in den Verdampfer 5 läuft. Mittels des schematisch dargestellten Gebläses 8 kann eine Kühlluftströmung 9 erzeugt werden, die die Wärmeabfuhr im Bereich der Kühlelemente 2 verstärkt.

Vorzugsweise besteht der Verdampfer aus einem monolithischen, keramischen Block, der aus zwei Halbschalen 10 zusammengesetzt ist, wie die Figur 1 zeigt, die entlang ihrer Verbindungsfläche bzw. Verbindungsebene 11 nach der Herstellung miteinander mit einem Epoxidharz verklebt sind. Als Füllung werden keramische Pulver, wie SiO2, SiC oder $Al_2O_3$ eingesetzt, um dadurch den thermischen Ausdehnungskoeffizienten des Epoxidklebers zu senken und an die beiden zu verbindenden Halbschalen 10 anzugleichen.

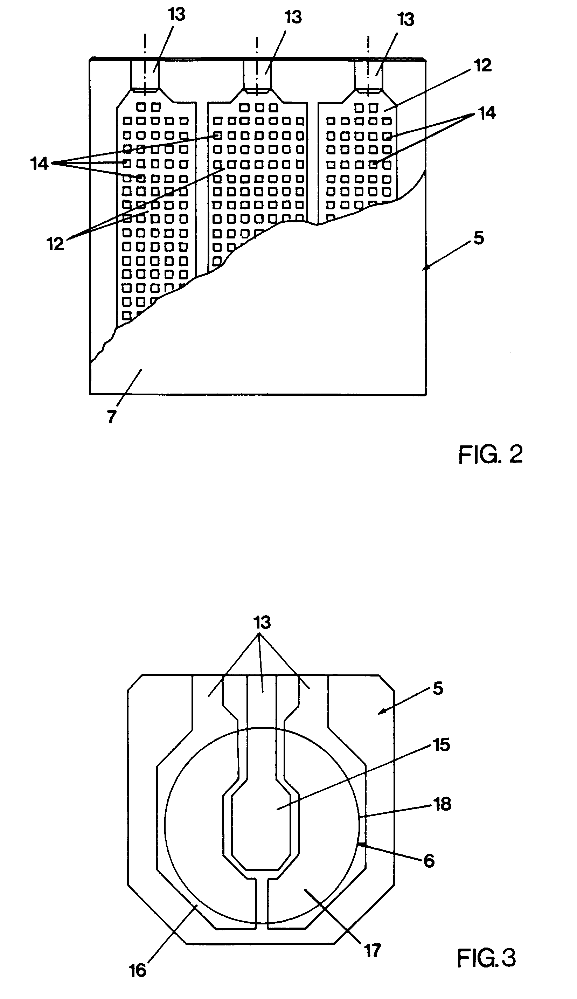

In dem Innern des Verdampfers 5 sind, wie die Ausführungsform der Figur 2 zeigt, drei einzelne Kammern 12 ausgebildet, die an ihrer Oberseite jeweils eine Anschlußöffnung 13 aufweisen, in der das keramische Zwischenrohr 4, wie dies die Figur 1 zeigt, eingefügt wird. Die Unterteilung des Verdampfers 5 gemäß der Ausführungsform der Figur 2 in drei Kammern dient dazu, unterschiedliche Flüssigkeiten aufzunehmen. So wird zum Beispiel in die eine Kammer 12 Wasser eingefüllt, das einen hohen Verdampfungspunkt besitzt, während in der zweiten Kammer Ethanol oder Isopropanol eingefüllt werden, um einen mittleren Temperaturbereich zu erfassen. In der dritten Kammer wird Methanol eingefüllt, das bereits ab -30°C die Verdampfungswirkung zeigt. Gerade durch den Aufbau des Verdampfers 5 aus der Keramik mit der erfindungsgemäßen Spezifizierung ist es zum einen möglich, Wasser einzusetzen, zum anderen wird eine gute elektrische Isolierung in Bezug auf die zu kühlenden elektrischen Bauteile 6 erzielt, die auf den ebenen Flächen 7 aufgebracht werden. Jede der drei Kammern mit dem zugeordneten Wärmerohr bildet ein für sich geschlossenes System.

An den Innenwänden der Halbschalen 10 im Bereich der Kammern 12 sind einzelne Zapfen mit quadratischem Querschnitt zu sehen, die so zu Feldern geordnet sind, daß zwischen den Zapfen 14 noch ausreichender Zwischenraum verbleibt, so daß die verdampfende Flüssigkeit in dem Wärmerohr 1 aufsteigen kann. Durch diese Zapfen wird die Wärmeaustauschfläche zwischen der Keramik und der Flüssigkeit groß gestaltet. Gerade in Verbindung mit dem Aufbau des Wärmetauschers aus den beiden Halbschalen 10 können diese Zapfen fertigungstechnisch einfach durch Schnitte oder Fräsvorgänge in dem Vollmaterial gebildet werden; alternativ können die Halbschalen in eine Form gegossen oder gepreßt werden, so daß ein Grünling entsteht, der anschließend gebrannt wird.

Die Verwendung von Wasser, das aufgrund der guten elektrischen Isolation der keramischen Halbschalen 10 möglich ist, senkt den thermischen Widerstand des Systems, da der Wärmetransport von Wasser wesentlich höher als derjenige von Chlorfluorkohlenwasserstoffe ist.

Eine weitere Ausführungsform des Wärmetauschers 5 der Figur 1 ist in der Figur 3 dargestellt. Diese Ausführungsform weist drei Kammern 15, 16 und 17 auf, wobei die Kammer zentral in der Mitte unter einem kreisrunden, durch den Kreis 18 in der Figur 3 angedeuteten, elektronischen Bauteil, das zu kühlen ist, positioniert ist. Um diese zentrale Kammer 15, die dann in einem solchen Fall vorzugsweise mit Methanol gefüllt ist, sind zwei äußere Kammern 16 und 17 in Form jeweils eines Halbkreises angeordnet, so daß die gesamte Montagefläche des elektronischen Bauteils 6 durch die Kammern 15, 16 und 17 unterlegt ist. Die beiden äußeren Kammern 16 und 17 mit zueinander spiegelsymmetrischer Halbkreisform sind vorzugsweise mit Wasser gefüllt. Wiederum besitzt jede Kammer an ihrer Oberseite des Verdampfers 5 eine Anschlußöffnung 13 für jeweils ein Wärmerohr 1. Auch bildet jede Kammer 15, 16 und 17 mit dem zugeordneten Wärmerohr ein eigenes, in sich geschlossenes System.

Auch in den Kammern 15, 16 und 17 der Figur 3 können Vorsprünge in Form von Zapfen und Stegen (nicht dargestellt) vorgesehen werden, um die Wärmeaustauschfläche zu vergrößern.

Wie bereits vorstehend anhand der Figur 1 erläutert wurde, wird das Wärmerohr 1, das aus Kupfer hergestellt ist, nicht unmittelbar mit dem Wärmetauscher 5 bzw. mit dessen Anschlußöffnungen 13 befestigt, da eine solche Anordnung zu Spannungen aufgrund der unterschiedlichen Ausdehnungskoeffizienten zwischen dem Kupfermaterial des Wärmerohrs und dem Keramikmaterial des Verdampfers 5 führen könnte. Aus diesem Grund ist in die Anschlußöffnungen 13 das erwähnte keramische Zwischenrohr 4 mittels des Epoxidharzklebers eingeklebt. Die Oberfläche der anderen Seite dieses keramischen Zwischenrohrs 4, die mit dem Zwischenstück in Form eines Faltenbalgs 3 verbunden ist, ist vorzugsweise metallisiert, so daß ein solcher Faltenbalg 3, beispielsweise aus Bronze und Edelstahl, verlötet oder angeschweißt werden kann. Dieser Faltenbalg 3 dient dazu, Längenänderungen in der Richtung der Rohrachse des Wärmerohrs, aber auch Schwingungen, aufzunehmen.

Versuche anhand erfindungsgemäßer Verdampfer haben gezeigt, daß die Leistungdaten gegenüber herkömmlichen Kühleinrichtungen, die Verdampfer aus Flachkupfer einsetzen, wesentlich verbessert werden können. Beispielsweise wurden Versuche an Kühleinrichtungen durchgeführt, deren Verdampfer aus Aluminiumnitridkeramikblöcken (Halbschalen 10) mit drei getrennten Kammern und jeweiligen Zapfenfeldern in den Kammern (siehe Figur 2) aufgebaut waren. Die Kammern der Verdampfer hatten Außenabmessungen von 120 mm x 120 mm x 15 mm. Die Anschlußrohre hatten einen Innendurchmesser von 10 mm, eine Länge von 70 mm, hergestellt aus Aluminiumoxid, glasiert, dran anschließend einen Metallfaltenbalg, Länge 25 mm, weichgelötet, um dran anschließend ein Kupferwärmerohr, das zum Kondensator führte (Aufbau entsprechend Figur 1). Als Flüssigkeit wurde in der mittleren Kammer Ethanol eingefüllt, während in den beiden äußeren Kammern ein Wasser/Glykol-Gemisch vorhanden war. Das Wärmeaustauschfeld im Innern des Verdampfers bestand aus Zapfen mit einer Kantenlänge von 3 mm und Kanälen dazwischen von 1,5 mm Breite. Die Tiefe betrug 9 mm, d.h. 4,5 mm je Halbschale 10. Bei einer Luftgeschwindigkeit von 5m/sec. der Luftströmung 9, die über den Kühllüfter 8 (siehe Figur 1) auf den Kondensator zugeführt wurde, wurde ein Wärmewiderstand von nur 0,019 K/W gemessen.

Dagegen wurde mit einem Verdampfer, der nach dem Stand der Technik aufgebaut war, bei gleicher Kühlluftgeschwindigkeit durch den Kondensator, von 5m/sec. ein Wärmewiderstand des Aufbaus von 0,045 K/w gemessen. Der hierfür eingesetzte Verdampfer bestand aus Flachkupfer mit einer Kantenlänge von 120 mm x 120 mm und einer Dicke von 20 mm, die Wärmerohre besaßen ebenfalls einen Innendurchmesser von 16 mm und als wärmeübertragende Flüssigkeit wurde darin FC72 eingesetzt.

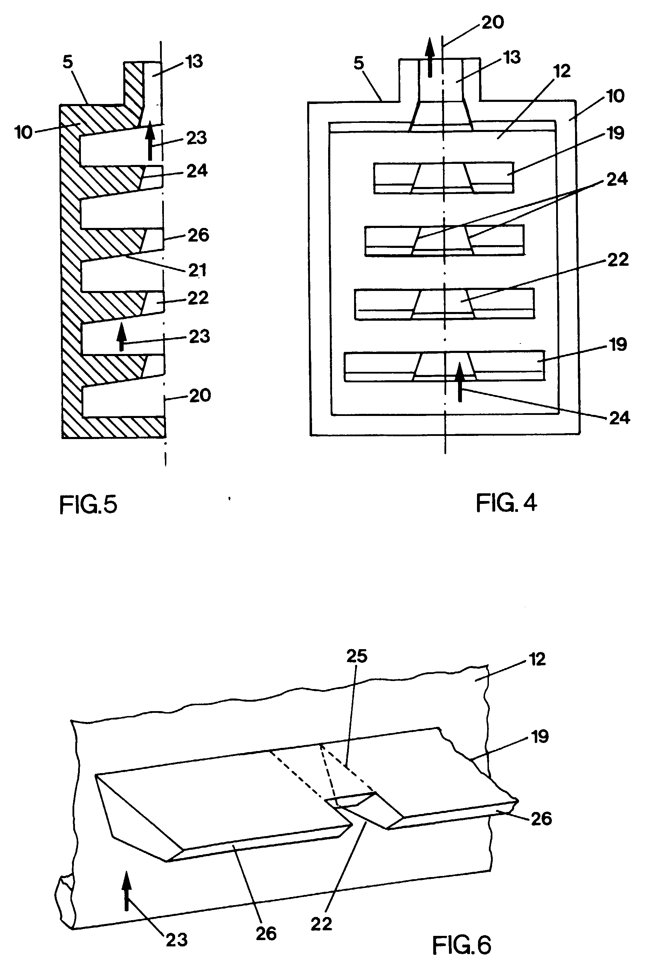

In den Figuren 4 und 5 ist eine weitere Halbschale 10 entsprechend der Halbschale 10 der Figur 1 des Verdampfers 5 gezeigt. Im Gegensatz zu der Halbschale, wie sie in Figur 2 dargestellt ist, sind in der Kammer der Halbschale der Figur 4 einzelne Stege 19 vorgesehen, die quer, d.h. etwa unter einem rechten Winkel, zu der Achse 20 des Verdampfers 5 verlaufen. Zur Vereinfachung der Darstellung ist in den Figuren 4 und 5 nur eine einzelne Kammer dargestellt, es ist jedoch ersichtlich, daß dieser Kammeraufbau in Bezug auf die Stege 12 auf das Mehrfachkammersystem, wie es beispielsweise in der Figur 3 dargestellt ist, übertragen werden kann. Die einzelnen Stege 19 besitzen an ihren von dem Wärmeübertragungsmittel angeströmten Seiten schräg nach oben verlaufende Flächen, so daß das Wärmeübertragungsmittel entlang dieser schrägen Flächen zu den Durchbrüchen 22 geführt wird. Die Hauptströmungsrichtung des Wärmeübertragungsmittels ist in Figur 5 mit dem Strömungspfeil 23 angezeigt. Wie in den Figuren 4 und 5 zu sehen ist, sind nicht nur die unteren, quer verlaufenden Flächen 21 nach oben geneigt, sondern auch die weiteren Stirnkanten 24, um eine Strömung des Wärmeübertragungsmittels mit geringem Strömungswiderstand entlang der einzelnen Flächen der Stege 19 zu erzielen. Darüberhinaus sind die einzelnen Stege 19, in Richtung der Strömungspfeile 23 gesehen, von dem unteren Steg 19 zu dem oberen Steg 19 hin mit einer sich verringernden Länge ausgebildet, so daß zu dem äußeren Rand hin, der die Kammern 12 begrenzt, ein sich vergrößernder Freiraum verbleibt, so daß gerade im oberen Bereich das verdampfende Wärmeübertragungsmittel schnell über die Anschlußöffnung 13 nach oben abgeführt werden kann.

In Figur 6 ist in einer vergrößerten Darstellung ein Steg 19, der mit den Stegen 19 der Figuren 4 und 5 vergleichbar ist, gezeigt. In dieser Darstellung sind die schrägen Stirnkanten 24 sowie die schrägen Anströmflächen 21 deutlich zu sehen. Die Stege können durch mehrere Durchbrüche 22, wie dies in Figur 6 gezeigt ist, unterbrochen sein, um mehrfache Durchgänge für das Wärmeübertragungsmittel zu schaffen, so daß annähernd eine unterteilte Struktur erzielt wird, wie sie in Figur 2 dargestellt ist. Darüberhinaus können diese Durchbrüche 22 bis zu dem Boden der Kammer 12 reichen, wie dies mit der unterbrochenen Linie 25 angedeutet ist.

Während in der Ausführungsform der Figuren 5 und 6, die eine Halbschale 10 zeigen, die Stirnkanten der Stege an der Achse 20 enden, so daß diese Stirnkanten 26 zweier solcher Halbschalen 10 aufeinander liegen, wäre es auch möglich, diese Stege 19 etwas kürzer auszubilden und über die gesamte Stirnfläche 26 abzuschrägen, so daß bei zusammengebautem Verdampfer 5 zwischen jeweils zwei gegenüberliegenden Stirnflächen 26 der beiden Halbschalen 10 ein schlitzartiger Durchbruch verbleibt.

## Patentansprüche

1. Kühleinrichtung, insbesondere für elektronische Schaltungen, mit mindestens einem Wärmerohr, das an seinem unten liegenden Ende einen Verdampfer aufweist und an seinem oben liegenden Ende mit Kühlelementen versehen ist, wobei der Verdampfer mindestens eine Kammer für zu verdampfendes, flüssiges Wärmeübertragungsmittel umfaßt, wobei der erzeugte Dampf im Verdampfer des Wärmerohrs im Bereich der Kühlelemente kondensiert und das Kondensat in die Kammer zurückfließt und der so gebildete Kreislauf nach außen dicht abgeschlossen ist, dadurch gekennzeichnet, daß der Verdampfer (5) aus einer wärmeleitenden Keramik mit einer Wärmeleitfähigkeit von mindestens $\lambda = 90 \frac{Watt}{M \cdot k}$ (bei 20°C) gebildet ist und daß der Verdampfer (5) mindestens zwei Einzelkammern aufweist, die jeweils mit einem Wärmerohr strömungsmäßig verbunden sind, wobei in die einzelnen Kammern (15, 16, 17) unterschiedliche Wärmeübertragungsmittel mit unterschiedlicher Verdampfungstemperatur eingefüllt sind.

2. Kühleinrichtung nach Anspruch 1, dadurch gekennzeichnet, daß in wenigstens eine der Kammern (15, 16, 17) Wasser eingefüllt ist.

3. Kühleinrichtung nach Anspruch 1 oder 2, dadurch gekennzeichnet, daß der Verdampfer (5) drei Einzelkammern (15, 16, 17) aufweist, wobei in die eine Kammer Metahnol, in die zweite Kammer Ethanol und/oder Isopropanol und in die dritte Kammer Wasser als Wärmeübertragungsmittel eingefüllt sind.

4. Kühleinrichtung nach einem der Ansprüche 1 bis 3, dadurch gekennzeichnet, daß die Keramik elektrisch isolierend ist mit einem elektrischen Widerstand oberhalb von $\rho = 10^{10} \, \Omega \cdot cm$.

5. Kühleinrichtung nach einem der Ansprüche 1 bis 4, dadurch gekennzeichnet, daß der Verdampfer (5) im wesentlichen aus Siliziumnitrid, Siliziumkarbid, Berylliumoxid oder Aluminiumnitrid, vorzugsweise Alumniumnitrid, gebildet ist.

6. Kühleinrichtung nach einem der Ansprüche 1 bis 5, dadurch gekennzeichnet, daß das Wärmerohr (1) zumindest im Bereich der Kühlelemente aus einem Metall, insbesondere Kupfer oder einer Kupfer-Legierung, gebildet ist.

7. Kühleinrichtung nach Anspruch 6, dadurch gekennzeichnet, daß zwischen dem Wärmerohr (19) und dem Verdampfer (5) ein Zwischenstück (3, 4) zur elektrischen Isolierung und/oder zum Ausgleichen von Wärmedehnungen angeordnet ist.

8. Kühleinrichtung nach Anspruch 7, dadurch gekennzeichnet, daß das Zwischenstück (4) aus Keramik gebildet ist.

9. Kühleinrichtung nach Anspruch 8, dadurch gekennzeichnet, daß das Zwischenstück (4) und der Verdampfer (5) mittels Aluminiumoxid oder Magnesiumsilikat miteinander verbunden sind.

10. Kühleinrichtung nach Anspruch 7, dadurch gekennzeichnet, daß das Zwischenstück als Faltenbalg (3) ausgebildet ist.

11. Kühleinrichtung nach Anspruch 8, dadurch gekennzeichnet, daß sich an das Zwischenstück ein Faltenbalg anschließt.

12. Kühleinrichtung nach einem der Ansprüche 8 oder 11, dadurch gekennzeichnet, daß einzelne Bauteile mittels Epoxidharz verklebt sind.

13. Kühleinrichtung nach Anspruch 12, dadurch gekennzeichnet, daß das Epoxidharz mit einem keramischen Pulver gefüllt ist.

14. Kühleinrichtung nach einem der Ansprüche 8, 10 oder 11, dadurch gekennzeichnet, daß einzelne Bauteile mittels Aktivlöten verbunden sind.

15. Kühleinrichtung nach Anspruch 1 bis 14, dadurch gekennzeichnet, daß der Verdampfer (5) aus mindestens zwei schalenförmigen Teilen (10) zusammengesetzt ist.

16. Kühleinrichtung nach Anspruch 1 bis 15, dadurch gekennzeichnet, daß die Innenwand der Kammer des Verdampfers (5) in Form von Erhebungen (14) und/oder Vertiefungen strukturiert ist.

17. Kühleinrichtung nach Anspruch 16, dadurch gekennzeichnet, daß die Erhebungen durch Zapfen (14) und/oder Stege gebildet sind.

18. Kühleinrichtung nach Anspruch 17, dadurch gekennzeichnet, daß die Zapfen (14) und die Stege eine Breite von 1 bis 10 mm, vorzugsweise 2 bis 5 mm, aufweisen.

19. Kühleinrichtung nach Anspruch 17 oder 18, dadurch gekennzeichnet, daß benachbarte Zapfen (14) und/oder Stege durch einen freien Raum mit einer Breite von 0,7 bis 5 mm, vorzugsweise 1 bis 3 mm, voneinander beabstandet sind.

20. Kühleinrichtung nach Anspruch 15, dadurch gekennzeichnet, daß die Kammer (12, 15, 16, 17) spiegelbildlich zur Verbindungsebene der schalenförmigen Teile ausgebildet ist.

21. Kühleinrichtung nach Anspruch 17 und Anspruch 20, dadurch gekennzeichnet, daß sich die Zapfen (14) und/oder Stege des einen schalenförmigen Teils an die Zapfen (14) und/oder Stege des anderen schalenförmigen Teils aneinander anschließen.

22. Kühleinrichtung nach einem der Ansprüche 17 bis 19, dadurch gekennzeichnet, daß mindestens ein Teil der Flächen (24, 26) der Stege (19) und/oder Zapfen, die von dem Wärmeübertragungsmittel, von dem Verdampfer zu den Kühlelementen hin gesehen, angeströmt werden, in Strömungsrichtung (23) zu ihren freien Kanten hin abgeschrägt verlaufen derart, daß sie Strömungsführungsflächen für das verdampfende, aufsteigende Wärmeübertragungsmittel bilden.

23. Kühleinrichtung nach einem der Ansprüche 1 bis 22, dadurch gekennzeichnet, daß auf der Außenseite des Verdampfers (5) Flächen (7) zur Aufnahme von elektronischen Bauteilen (6) vorgesehen sind.

FIG. 1

FIG. 2

FIG. 3

FIG.5

FIG. 4

FIG.6